# EUROPEAN PATENT APPLICATION

(11) **EP 0 588 370 A2**
(43) Date of publication of application: **23.03.1994**
(21) Application number: 93115113.8
(22) Date of filing: 20.09.1993
(51) Int. Cl.: H01L 29/784, H01L 21/336

(54) **Manufacturing method of thin film transistor and semiconductor device utilized for liquid crystal display**

(30) Priority: 18.09.1992 JP 249075/92; 15.12.1992 JP 334699/92
(71) Applicant: MATSUSHITA ELECTRIC INDUSTRIAL CO., LTD., Kadoma-shi, Osaka-fu, 571 (JP)
(72) Inventor: Sano, Hiroshi, Hirakata-shi, Osaka (JP); Furuta, Mamoru, Hirakata-shi, Osaka (JP); Yoshioka, Tatsuo, Hirakata-shi, Osaka (JP); Kawamura, Tetsuya, Hirakata-shi, Osaka (JP); Miyata, Yutaka, Ikoma-shi, Nara-ken (JP)
(74) Representative: Pellmann, Hans-Bernd, Dipl.-Ing.

(57) **Abstract**

A manufacturing method of a thin film transistor consists of the steps of depositing an active semiconductor layer, a gate insulating layer, and a gate electrode on a transparent glass substrate in that order, forming source and drain regions by doping impurities into the active semiconductor layer according to an ion implantation method while functioning the gate electrode as a mask against the impurities, oxidizing a side portion of the gate electrode according to an anodic oxidation processing to form an anodic oxidation layer made of an insulating material, depositing a layer-insulation layer on the gate electrode and the anodic oxidation layer, and connecting source and drain electrodes to the source and drain regions. A channel region not doped with the impurities is formed in the active semiconductor layer between the source and drain regions, and an off set region positioned just under the anodic oxidation layer is formed in a portion of the channel region adjacent to the drain region. Therefore, an off current flowing from the drain region to the source region is decreased in a backward bias condition because of the off set region, so that a picture signal can be stored in the thin film transistor for a long time.

## Description

### BACKGROUND OF THE INVENTION

### 1. FIELD OF THE INVENTION:

The present invention relates to a manufacturing method of a thin film transistor utilized for a liquid crystal display and an image sensor and relates to the thin film transistor manufactured according to the method. Also, the present invention relates to a semiconductor apparatus in which a large number of thin film transistors are arranged on the same substrate to be utilized for the liquid crystal display.

### 2. DESCRIPTION OF THE RELATED ART:

A thin film transistor has been conventionally utilized as a switching device for switching pixels in a liquid crystal display. In this case, a picture signal is, for example, stored in each of the thin film transistors in a backward bias condition. However, a leak current (hereinafter the leak current is called an off current) undesirably flows out from a drain region to a source region in the thin film transistor even though the thin film transistor is in the backward bias condition, so that a storing characteristic of a picture signal is damaged by the off current. Therefore, the reduction of the off current is required.

To reduce the off current, it is effective to decrease intensity of electric field induced in a channel region adjacent to the drain region. Therefore, the thin film transistor is manufactured in an offset structure or a lightly doped drain structure. For example, the structures have been proposed in literatures "Extended Abstracts of the 1992 International Conference on Solid State Devices and Materials (1992) pp. 52-54" and "Extended Abstracts of the 1991 International Conference on Solid State Devices and Materials (1991) pp. 641-643".

### 2.1. PREVIOUSLY PROPOSED ART:

A conventional manufacturing method of a thin film transistor in which an offset structure or a lightly doped drain structure is formed is described.

A gate electrode is arranged on a semiconductor layer through a gate insulating layer. Thereafter, a photomask functioning as a photoresist is coated on the gate insulating layer, and the photomask is patterned according to a photo lithography. In this case, the patterned photomask is positioned according to a predetermined design to cover the gate electrode and a surrounding region adjacent to the gate electrode with the photomask. Thereafter, a drain region and a source region are formed by implanting impurities into the semiconductor layer while preventing the impurities from passing through the photomask. As a result, a thin film transistor in which electrons or positive holes transmit from the source region to the drain region through a channel region under control of electric field induced by a gate voltage applied to the gate electrode is manufactured.

Because the surrounding area adjacent to the gate electrode is covered with the photomask, an off set region not positioned just under the gate electrode but positioned just under the surrounding area is formed in a portion of the channel region adjacent to the drain region. Therefore, the intensity of the electric field induced in the channel region is decreased in the off set region because the off set region is not positioned just under the gate electrode, so that the off current is reduced.

Also, in cases where a lightly doped drain region adjacent to the drain region is formed, the density of the electrons or the positive holes passing through the lightly doped drain region is decreased even though the intensity of the electric field induced in the lightly doped drain region is high because the density of the impurities doped in the lightly doped drain region is low.

### 2.2. PROBLEMS TO BE SOLVED BY THE INVENTION:

However, the positioning of the patterned photomask depends on the precision of a mask alignment in the photo lithography as a matter of fact. That is, the patterned photomask actually positioned according to the photo lithography differs from that expected to be positioned according to the predetermined design. Therefore, it is difficult to precisely position and minutely form the off set region or the lightly doped drain region in a portion of the channel region adjacent to the drain region.

Also, in cases where a large number of thin film transistors are formed on the same insulating substrate such as a glass substrate to manufacture a semiconductor apparatus, it is difficult to uniformly form the off set regions or the lightly doped drain regions in the thin film transistors because the insulating substrate thermally expands or contracts.

### 2.3. ANOTHER PREVIOUSLY PROPOSED ART:

There is Japanese Patent Application No. 273376 of 1991 laid open to public inspection under Provisional Publication No. 90512/93 (H5-90512) as another previously proposed art.

In J.P.A. No. 273376, a large number of semiconductor integrated circuits are arranged on a semiconductor substrate, and all surfaces of a gate electrode are oxidized according to an anodic oxidation processing to insulate the gate electrode from source and drain wirings. Therefore, upper and side surfaces of the gate electrodes are thickly covered with an oxide layer to reliably insulate the gate electrode.

In the above configuration, even though the formation of the oxide layer results in the formation of an off set region in the result, the width of the off set region cannot be minutely adjusted because it is required to thickly cover the gate electrode with the oxide layer. Also, because an upper surface of the gate electrode is inevitably covered with the oxide layer, it is required to form a contact hole reaching the upper surface of the gate electrode to connect a gate wiring to the gate electrode.

### SUMMARY OF THE INVENTION

A first object of the present invention is to provide, with due consideration to the drawbacks of such a conventional manufacturing method of a thin film transistor, a manufacturing method of a thin film transistor in which an offset region is formed with high precision. In addition to the off set region, the first object is also to provide the method in which a lightly doped drain region is formed with high precision.

A second object is to provide a thin film transistor manufactured according to the above method.

A third object is to provide a semiconductor apparatus in which a large number of thin film transistors are uniformly arranged on the same insulating substrate.

The first object is achieved by the provision of a manufacturing method of a thin film transistor, comprising the steps of:
forming a semiconductor thin layer on a transparent insulating substrate;
forming an insulating layer on the semiconductor thin layer;
forming a gate electrode on the insulating layer, the gate electrode being positioned over a first portion of the semiconductor thin layer;
doping impurities into second portions of the semiconductor thin layer by utilizing the gate electrode as a mask which prevents the impurities from passing though the gate electrode, the second portions of the semiconductor thin layer doped with the impurities being changed to a source region and a drain region, and a channel region not doped with the impurities being formed in the first portion of the semiconductor thin layer which is positioned just under the gate electrode and is positioned between the source and drain regions; and
reforming a side portion of the gate electrode to a reformed layer made of an insulating material to form an off set region positioned just under the reformed layer in the channel region adjacent to the drain region, intensity of electric field induced in the channel region by applying a voltage to the gate electrode of which the side portion is reformed being low in the off set region.

In the above steps of the manufacturing method, the second portions of the semiconductor thin layer which is not positioned under the gate electrode are changed to the source and drain regions by doping the impurities. Also, because the gate electrode functions as a mask against the impurities, the channel region not doped with the impurities is formed in the first portion of the semiconductor thin layer which is positioned just under the gate electrode.

Thereafter, the side portion of the gate electrode is reformed to the reformed layer made of the insulating material. For example, the reformed layer is formed by oxidizing the side portion of the gate electrode. Therefore, the width of the gate electrode is decreased, so that a reduced gate electrode is formed. Also, because the reformed layer is made of the insulating material, the reformed layer does not function as an electrode. Therefore, the off set region not positioned just under the reduced gate electrode is formed in the channel region adjacent to the drain region.

In cases where a voltage is applied to the reduced gate electrode when the thin film transistor is set in a backward condition, electric field is highly induced in the channel region because the channel region is positioned just under the reduced gate electrode. In contrast, the intensity of the electric field induced in the off set region is lowered because the off set region is not positioned just under the reduced gate electrode. Therefore, an off current flowing from the drain region to the source region is considerably reduced, so that information such as a picture signal can be reliably stored in the thin film transistor for a long time without any deterioration.

Also, because no reformed layer is arranged on an upper surface of the reduced gate electrode, a gate wiring can be easily connected to the reduced gate electrode without digging any contact hole on the reduced gate electrode. Accordingly, the thin film transistor can be easily manufactured.

Also, the first object is achieved by the provision of a manufacturing method of a thin film transistor, comprising the steps of:
forming a semiconductor thin layer on a transparent insulating substrate;
forming an insulating layer on the semiconductor thin layer;
forming a gate electrode on the insulating layer, the gate electrode being positioned over a first portion of the semiconductor thin layer;
reforming a side portion of the gate electrode to a reformed layer made of an insulating material, the gate electrode being changed to a reduced gate electrode; and
doping impurities into second portions of the semiconductor thin layer by utilizing both the reduced gate electrode and the reformed layer as a mask which prevents the impurities from passing though both the reduced gate electrode and the reformed layer, the second portions of the semiconductor thin layer doped with the impurities being changed to a source region and a drain region, a channel region not doped with the impurities being formed in the semiconductor thin layer which is positioned just under both the reduced gate electrode and the reformed layer and is positioned between the source and drain regions, an off set region positioned just under the reformed layer being formed in the channel region adjacent to the drain region, and intensity of electric field induced in the channel region by applying a voltage to the reduced gate electrode being low in the off set region.

In the above steps of the manufacturing method, the side portion of the gate electrode is reformed to the reformed layer made of the insulating material. For example, the reformed layer is formed by oxidizing the side portion of the gate electrode. Therefore, the width of the gate electrode is decreased, so that the reduced gate electrode is formed. Thereafter, the second portions of the semiconductor thin layer which is not positioned under the reduced gate electrode or the reformed layer are changed to the source and drain regions by doping the impurities. Also, because the reduced gate electrode and the reformed layer function as a mask against the impurities, the channel region not doped with the impurities is formed in the semiconductor thin layer positioned just under the reduced gate electrode and the reformed layer.

Also, because the reformed layer is made of the insulating material, the reformed layer does not function as an electrode. Therefore, the off set region positioned just under the reformed layer is formed in the channel region adjacent to the drain region.

In cases where a voltage is applied to the reduced gate electrode when the thin film transistor is set in a backward condition, electric field is highly induced in the channel region positioned just under the reduced gate electrode. In contrast, the intensity of the electric field induced in the off set region is lowered because the off set region is not positioned just under the reduced gate electrode. Therefore, an off current flowing from the drain region to the source region is considerably reduced, so that information such as a picture signal can be reliably stored in the thin film transistor for a long time without any deterioration.

Also, because no reformed layer is arranged on an upper surface of the reduced gate electrode, a gate wiring can be easily connected to the reduced gate electrode without digging any contact hole on the reduced gate electrode. Accordingly, the thin film transistor can be easily manufactured.

Also, the first object is achieved by the provision of a manufacturing method of a thin film transistor, comprising the steps of:
forming a semiconductor thin layer on a transparent insulating substrate;
forming an insulating layer on the semiconductor thin layer;
forming a gate electrode on the insulating layer, the gate electrode being positioned over a first portion of the semiconductor thin layer;
slightly doping first impurities into second portions of the semiconductor thin layer by utilizing the gate electrode as a mask which prevents the first impurities from passing though the gate electrode, the second portions of the semiconductor thin layer doped with the first impurities being changed to a source region slightly doped and a drain region slightly doped, and a channel region not doped with the first impurities being formed in the first portion of the semiconductor thin layer which is positioned just under the gate electrode and is positioned between the source and drain regions slightly doped;
reforming a side portion of the gate electrode to a reformed layer made of an insulating material to form an off set region positioned just under the reformed layer in the channel region adjacent to the drain region, the gate electrode being changed to a reduced gate electrode, intensity of electric field induced in the channel region by applying a voltage to the reduced gate electrode being lowered in the off set region, and the reformed layer being formed while the side portion of the gate electrode is swollen out to position a first portion of the drain region adjacent to the off set region just under the reformed layer; and
heavily doping second impurities into the source and drain regions slightly doped by utilizing both the reduced gate electrode and the reformed layer as a mask which prevents the second impurities from passing though both the reduced gate electrode and the reformed layer, the source and drain regions doped with the second impurities being changed to the source and drain regions heavily doped, the first portion of the drain region being not heavily doped with the second impurities to function as a lightly doped drain region positioned between the off set region and the drain region heavily doped.

In the above steps of the manufacturing method, the second portions of the semiconductor thin layer which is not positioned under the gate electrode are changed to the source and drain regions by slightly doping the first impurities. Also, because the gate electrode functions as a mask against the first impurities, the channel region not doped with the first impurities is formed in the first portion of the semiconductor thin layer which is positioned just under the gate electrode.

Thereafter, the side portion of the gate electrode is reformed to the reformed layer made of the insulating material. For example, the reformed layer is formed by oxidizing the side portion of the gate electrode. In this case, the reformed layer is formed while the side portion of the gate electrode is swollen out because the side portion is, for example, oxidized. Therefore, a first portion of the drain region adjacent to the off set region is positioned just under the reformed layer. Also, because the side portion of the gate electrode is changed to the reformed layer, the width of the gate electrode is decreased, and the gate electrode is changed to the reduced gate electrode. In addition, because the reformed layer is made of the insulating material, the reformed layer does not function as an electrode. Therefore, the off set region not positioned just under the reduced gate electrode is formed in the channel region adjacent to the drain region.

Thereafter, the source and drain regions slightly doped are changed to the source and drain regions heavily doped by doping the second impurities. Also, because the reduced gate electrode and the reformed layer function as a mask against the second impurities, the channel region and the first portion of the drain region are not doped with the second impurities. Therefore, the first portion of the drain region functioning as a slightly doped drain region is positioned between the off set region and the drain region heavily doped.

In cases where a voltage is applied to the reduced gate electrode when the thin film transistor is set in a backward condition, electric field is highly induced in the channel region positioned just under the reduced gate electrode. In contrast, the intensity of the electric field induced in the off set region is lowered because the off set region is not positioned just under the reduced gate electrode. Therefore, an off current flowing from the drain region to the source region is considerably reduced. Also, because the density of the first impurities doped in the slightly doped drain region is low, the off current flowing through the slightly doped drain region is suppressed to a low degree. That is, the off current is considerably reduced by the slightly doped drain region positioned between the drain region heavily doped and the off set region.

Accordingly, information such as a picture signal can be reliably stored in the thin film transistor for a long time without any deterioration.

Also, because no reformed layer is arranged on an upper surface of the reduced gate electrode, a gate wiring can be easily connected to the reduced gate electrode without digging any contact hole on the reduced gate electrode. Accordingly, the thin film transistor can be easily manufactured.

The second object is achieved by the provision of a thin film transistor comprising:
a transparent insulating substrate;
a source region arranged on the transparent insulating substrate;
a drain region arranged on the transparent insulating substrate;
a channel region arranged between the source and drain regions, charged particles being transferred from the source region to the drain region through the channel region;
an insulating layer for insulating the source region, the drain region, and the channel region;
a gate electrode arranged on the insulating layer just over a first portion of the channel region to form an off set region which is positioned in a second portion of the channel region adjacent to the drain region and is not positioned just under the gate electrode; and
a reformed layer made of an insulating material surrounding a side surface of the gate electrode, the reformed layer being formed by reforming a side portion of the gate electrode, the off set region being positioned just under the reformed layer.

In the above configuration, because the off set region not positioned just under the gate electrode is arranged in the second portion of the channel region adjacent to the drain region, the density of electric field induced in the channel region is lowered in the off set region, and an off current flowing from the drain region to the source region through the off current region is considerably reduced in a backward bias condition. Accordingly, information such as a picture signal can be reliably stored in the thin film transistor for a long time without any deterioration of the information.

The third object is achieved by the provision of a semiconductor apparatus, comprising:
a transparent insulating substrate;
a thin film transistor array composed of a plurality of thin film transistors arranged in array on the transparent insulating substrate, each of the thin film transistor comprising
a source region arranged on the transparent insulating substrate;
a drain region arranged on the transparent insulating substrate;
a channel region arranged between the source and drain regions, charged particles being transferred from the source region to the drain region through the channel region;
an insulating layer for insulating the source region, the drain region, and the channel region;
a gate electrode arranged on the insulating layer just over a first portion of the channel region to form an off set region which is positioned in a second portion of the channel region adjacent to the drain region and is not positioned just under the gate electrode; and
a reformed layer made of an insulating material surrounding a side surface of the gate electrode, the reformed layer being formed by reforming a side portion of the gate electrode, the off set region being positioned just under the reformed layer.
a plurality of gate bus wirings, connected to the gate electrodes of the thin film transistors in the thin film transistor array, for transferring gate signals to the gate electrodes;
a plurality of source bus wirings, connected to the source regions of the thin film transistors in the thin film transistor array, for transferring picture signals to the source regions; and
a plurality of pixel electrodes connected to the drain regions for storing the picture signals transferred from the source bus wirings through the source regions under control of the gate signals applied to the gate electrodes through the gate bus wirings.

In the above configuration, because the off set region not positioned just under the gate electrode is arranged in the second portion of the channel region adjacent to the drain region, the density of electric field induced in the channel region is lowered in the off set region, and an off current flowing from the drain region to the source region through the off current region is considerably reduced in a backward bias condition. Accordingly, the picture signal stored in the pixel electrodes can be reliably stored for a long time without any deterioration of the picture signals .

### BRIEF DESCRIPTION OF THE DRAWINGS

The objects, features and advantages of the present invention will be apparent from the following description taken in conjunction with the accompanying drawings, in which:
Figs. 1A to 1D are respectively a cross sectional view showing a manufacturing method of a coplanar type of thin film transistor according to a first embodiment of the present invention;
Figs. 2A to 2D are respectively a cross sectional view showing a manufacturing method of a coplanar type of thin film transistor according to a second embodiment of the present invention;
Figs. 3A to 3C and 3E are respectively a cross sectional view showing a manufacturing method of a coplanar type of thin film transistor according to a third embodiment of the present invention;
Fig. 3D is an enlarged view of an anodic oxidation layer and a channel region shown in Fig. 3C;
Figs. 4A to 4D and 4F are respectively a cross sectional view showing a manufacturing method of a coplanar type of thin film transistor according to a fourth embodiment of the present invention;
Fig. 4E is an enlarged view of an anodic oxidation layer and a channel region shown in Fig. 4D;
Figs. 5A to 5D are respectively a cross sectional view showing a manufacturing method of a coplanar type of thin film transistor according to a fifth embodiment of the present invention;
Fig. 6 is a schematic plan view of a semiconductor apparatus according to a sixth embodiment of the present invention; and
Fig. 7 is a schematic plan view of a semiconductor apparatus according to a seventh embodiment of the present invention.

### DETAIL DESCRIPTION OF THE PREFERRED EMBODIMENTS

Preferred embodiments of a manufacturing method of a thin film transistor and the thin film transistor according to the present invention are described with reference to drawings.

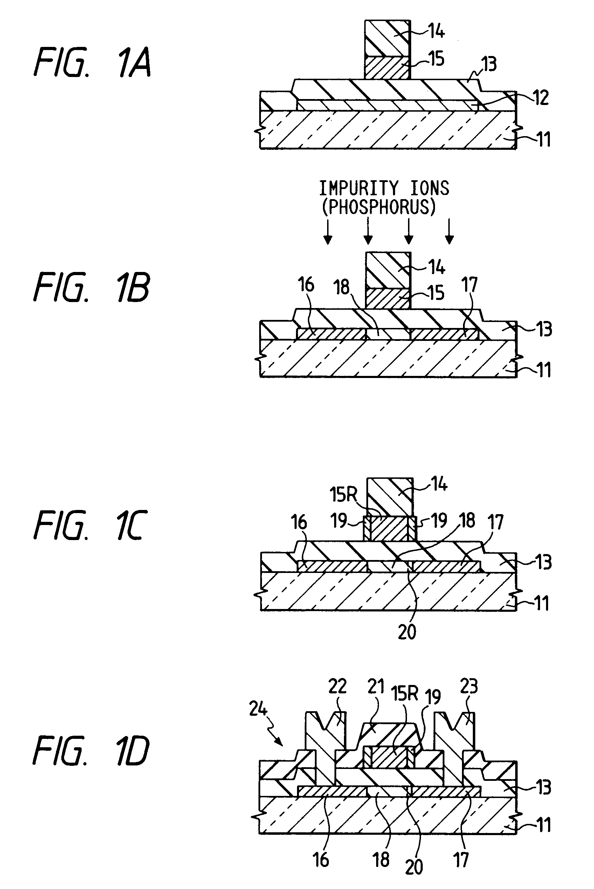

Figs. 1A to 1D are respectively a cross sectional view showing a manufacturing method of a coplanar type of thin film transistor according to a first embodiment of the present invention, the thin film transistor manufactured according to the method being shown in Fig. 1D.

As shown in Fig. 1A, polycrystalline silicon is initially deposited on a transparent glass substrate 11 according to a low pressure chemical vapor deposition (LP-CVD) method to form a thin film. Thereafter, the polycrystalline silicon thin film is divided into a large number of island-shaped regions according to a photolithography process and an etching process. Each of the regions is called an active semiconductor layer 12, so that the active semiconductor layer 12 made of the polycrystalline silicon is formed on the substrate 11. Thereafter, silicon dioxide is deposited on the active semiconductor layer 12 and the substrate 11 according to the LP-CVD method to insulate the active semiconductor layer 12 from the outside. Therefore, a gate insulating layer 13 made of the silicon dioxide is formed on the active semiconductor layer 12. Thereafter, aluminium is deposited on the gate insulating layer 13, and a photoresist layer 14 is coated on the aluminium deposited. Thereafter, the photoresist layer 14 is patterned according to the photolithography process, and the patterned photoresist layer 14 is removed while leaving the patterned photoresist layer 14 coated just over a central (first) portion of the active semiconductor layer 12 through the gate insulating layer 13. Thereafter, the aluminium is etched according to the etching process while leaving the aluminium covered with the photoresist layer 14 not removed. Therefore, a gate electrode 15 made of the aluminium is formed over the central portion of the active semiconductor layer 12 through the gate insulating layer 13. In this case, the photoresist layer 14 coated on the gate electrode 15 is left to prevent the gate electrode 15 from being oxidized in a following step.

Thereafter, as shown in Fig. 1B, impurity ions such as phosphorus are doped into the active semiconductor layer 12 through the gate insulating layer 13 according to an ion implantation method. In this case, the photoresist layer 14 and the gate electrode 15 function as a mask to prevent the impurity ions from being doped into the active semiconductor layer 12. Therefore, a source region 16 and a drain region 17 respectively doped with the impurity ions are formed in second portions of the active semiconductor layer 12, and a channel region 18 not doped with the impurity ions is formed in the central (first) portion of the active semiconductor layer 12 positioned just under the gate electrode 15.

Thereafter, as shown in Fig. 1C, a side portion of the gate electrode 15 is oxidized according to an anodic oxidation processing performed in a solution method, so that an anodic oxidation layer 19 made of aluminium oxide is formed as a reformed layer in the side portion of the gate electrode 15. Because the aluminium oxide is an insulating material, the anodic oxidation layer 19 does not function as an electrode. Also, because the side portion of the gate electrode 15 is chemically changed to the anodic oxidation layer 19, the width of the gate electrode 15 is decreased, and the gate electrode 15 is changed to a reduced gate electrode 15R. Therefore, a portion of the channel region 18 adjacent to the source and drain regions 16, 17 is not positioned just under the reduced gate electrode 15R. Accordingly, an off set region 20, which is not positioned just under the reduced gate electrode 15R but positioned just under the anodic oxidation layer 19, is formed in the portion of the channel region 18 adjacent to the drain region 17.

Also, because the side portion of the gate electrode 15 reacts chemically with oxygen atoms, the side portion is swollen out while changing to the anodic oxidation layer 19. Therefore, a summed mask area of the reduced gate electrode 15R and the anodic oxidation layer 19 becomes larger than that of the gate electrode 15. In addition, even though the side portion of the gate electrode 15 is oxidized, an upper surface of the gate electrode 15 is not oxidized because the photoresist layer 14 is left on the gate electrode 15. Thereafter, the photoresist layer 14 coated just over the gate electrode 15 is removed, and a gate wiring is connected to the upper surface of the reduced gate electrode 15R.

Thereafter, as shown in Fig. 1D, silicon dioxide is deposited on the reduced gate electrode 15R and the layers 13, 19 according to a normal pressure-CVD method to insulate the reduced gate electrode 15R from the outside, so that a layer-insulation layer 21 made of the silicon dioxide is formed on the reduced gate electrode 15R and the layers 13, 19. Thereafter, contact holes reaching the source and drain regions 16, 17 through the layer-insulation layer 21 and the gate insulating layer 13 are formed according to the photolithography process and the etching process. Thereafter, titanium is deposited on the source and drain regions 16, 17, and aluminium is deposited on the titanium. Therefore, the contact holes are buried with the titanium and the aluminium, so that a source electrode 22 and a drain electrode 23 respectively made of the titanium and the aluminium are formed. In the above steps, a thin film transistor 24 in which the off set region 20 is formed with high precision is manufactured.

In the above configuration of the thin film transistor 24 shown in Fig. 1D, when a gate voltage is applied to the reduced gate electrode 15R, electric field is concentratedly induced in the channel region 18 which is positioned just under the reduced gate electrode 15R. In contrast, the intensity of the electric field induced in the off set region 20 becomes low because the off set region 20 is not positioned just under the reduced gate electrode 15R. Therefore, when the thin film transistor 24 is set in the backward bias condition, electrons or positive holes flowing from the drain region 17 to the source region 16 are considerably reduced because the intensity of the electric field induced in the off set region 20 is low.

Accordingly, the off current can be effectively reduced in the backward bias condition, so that information such as a picture signal can be stored in the drain region 17 of the thin film transistor 24 for a long time without any deterioration of the information.

Also, because a width of the off set region 20 agrees with a reduced width of the reduced gate electrode 15R, the width of the off set region 20 can be minutely set with high precision by adjusting the reduced width of the reduced gate electrode 15R. In other words, it is not required to precisely perform a mask matching between the photoresist 14 and the gate electrode 15.

Also, because the anodic oxidation layer 19 is not formed on the upper surface of the reduced gate electrode 15R, a gate wiring can be easily connected to the reduced gate electrode 15R without digging any contact hole on the reduced gate electrode 15R.

Also, even though a large number of thin film transistors 24 are manufactured on the same substrate 11, the widths of the off set regions 20 can be uniformly set.

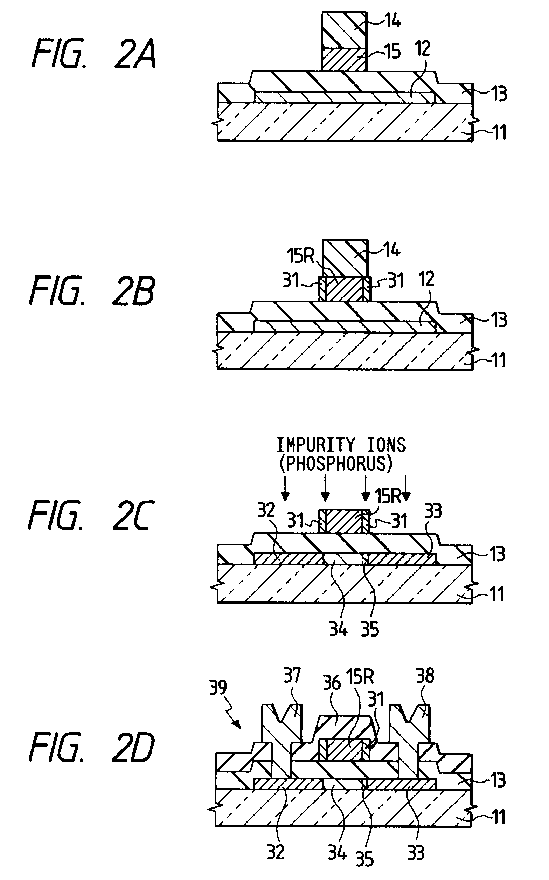

Next, a second embodiment of the present invention is described with reference to Figs. 2A to 2D.

Figs. 2A to 2D are respectively a cross sectional view showing a manufacturing method of a coplanar type of thin film transistor according to a second embodiment of the present invention, the thin film transistor manufactured according to the method being shown in Fig. 2D.

As shown in Fig. 2A, polycrystalline silicon is initially deposited on the transparent glass substrate 11 according to the LP-CVD method to form a thin film. Thereafter, the polycrystalline silicon thin film is divided into a large number of island-shaped regions according to the photolithography process and the etching process to form the active semiconductor layer 12 made of the polycrystalline silicon on the substrate 11. Thereafter, silicon dioxide is deposited on the active semiconductor layer 12 and the substrate 11 according to the LP-CVD method to insulate the active semiconductor layer 12 from the outside. Therefore, the gate insulating layer 13 made of the silicon dioxide is formed on the active semiconductor layer 12. Thereafter, aluminium is deposited on the gate insulating layer 13, and the photoresist layer 14 is coated on the aluminium deposited. Thereafter, the photoresist layer 14 is patterned according to the photo lithography process, and the patterned photoresist layer 14 is removed while leaving the patterned photoresist layer 14 coated just over a central (first) portion of the active semiconductor layer 12 through the gate insulating layer 13. Thereafter, the aluminium is etched according to the etching process while leaving the aluminium covered with the photoresist layer 14 not removed. Therefore, a gate electrode 15 made of the aluminium is formed over the central portion of the active semiconductor layer 12 through the gate insulating layer 13. In this case, the photoresist layer 14 coated on the gate electrode 15 is left to prevent the gate electrode 15 from being oxidized in a following step.

Thereafter, as shown in Fig. 2B, a side portion of the gate electrode 15 is oxidized according to the anodic oxidation processing performed in the solution method, so that an anodic oxidation layer 31 made of aluminium oxide is formed as a reformed layer in the side portion of the gate electrode 15. Because the aluminium oxide is an insulating material, the anodic oxidation layer 31 does not function as an electrode. Also, because the side portion of the gate electrode 15 is chemically changed to the anodic oxidation layer 31, the width of the gate electrode 15 is decreased, and the gate electrode 15 is changed to the reduced gate electrode 15R. Also, because the side portion of the gate electrode 15 reacts chemically with oxygen atoms, the side portion is swollen out while changing to the anodic oxidation layer 31. Therefore, a summed mask area of the reduced gate electrode 15R and the anodic oxidation layer 31 becomes larger than that of the gate electrode 15. In addition, even though the side portion of the gate electrode 15 is oxidized, an upper surface of the gate electrode 15 is not oxidized because the photoresist layer 14 is left on the gate electrode 15. Thereafter, the photoresist layer 14 coated just over the gate electrode 15 is removed, and a gate wiring is connected to the upper surface of the reduced gate electrode 15R.

Thereafter, as shown in Fig. 2C, impurity ions such as phosphorus are doped into the active semiconductor layer 12 through the gate insulating layer 13 according to the ion implantation method. In this case, the reduced gate electrode 15R and the anodic oxidation layer 31 function as a mask to prevent the impurity ions from being doped into the active semiconductor layer 12. Therefore, a source region 32 and a drain region 33 respectively doped with the impurity ions are formed in second portions of the active semiconductor layer 12, and a channel region 34 not doped with the impurity ions is formed in a third portion of the active semiconductor layer 12 positioned between the source and drain regions 32, 33. Because the channel region 34 is positioned just under the reduced gate electrode 15R and the anodic oxidation layer 31, an off set region 35 is formed in the channel region 34 which is positioned just under the anodic oxidation layer 31 and adjoins to the drain region 33. That is, the off set region 35 is not positioned just under the reduced gate electrode 15R, and a width of the off set region 35 agrees with that of the anodic oxidation layer 31.

Thereafter, as shown in Fig. 2D, silicon dioxide is deposited on the reduced gate electrode 15R and the layers 13, 31 according to the normal pressure-CVD method to insulate the reduced gate electrode 15R from the outside, so that a layer-insulation layer 36 made of the silicon dioxide is formed on the reduced gate electrode 15R and the layers 13, 31. Thereafter, contact holes reaching the source and drain regions 32, 33 through the layer-insulation layer 36 and the gate insulating layer 13 are formed according to the photo lithography process and the etching process. Thereafter, titanium is deposited on the source and drain regions 32, 33, and aluminium is deposited on the titanium. Therefore, the contact holes are buried with the titanium and the aluminium, so that a source electrode 37 and a drain electrode 38 respectively made of the titanium and the aluminium are formed. In the above steps, a thin film transistor 39 in which the off set region 35 is formed with high precision is manufactured.

Accordingly, because the off set region 35 not positioned just under the reduced gate electrode 15R is formed, the intensity of electric field induced in the off set region 35 is lowered. Therefore, the off current flowing from the drain region 33 to the source region 32 can be effectively reduced in the backward bias condition, and information such as a picture signal can be stored in the thin film transistor 39 for a long time without any deterioration.

Also, because a width of the off set region 35 agrees with the width of the anodic oxidation layer 31, the width of the off set region 35 can be minutely set with high precision by adjusting the width of the anodic oxidation layer 31.

Also, the width of the anodic oxidation layer 31 agreeing with the width of the off set region 35 is larger than a reduced width of the reduced gate electrode 15R agreeing with the width of the off set region 20 shown Fig. 1D, the width of the anodic oxidation layer 31 can be thinned as compared with that of the anodic oxidation layer 19 on condition that the off set region 35 can be reliably formed.

Also, even though the side portion of the gate electrode 15 is not swollen out when the side portion changes to the anodic oxidation layer 31, the off set region 35 can be reliably formed because the width of the off set region 35 is equivalent to the reduced width of the reduced gate electrode 15R.

Also, because the anodic oxidation layer 31 is not formed on the upper surface of the reduced gate electrode 15R, a gate wiring can be easily connected to the reduced gate electrode 15R without digging any contact hole on the reduced gate electrode 15R.

Also, even though a large number of thin film transistors 39 are manufactured on the same substrate 11, the widths of the off set regions 35 can be uniformly set.

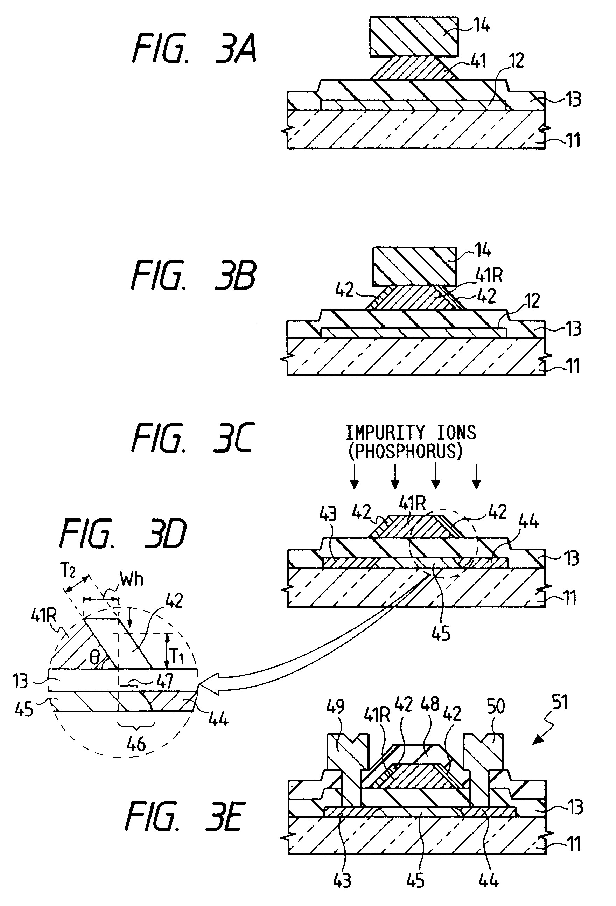

Next, a third embodiment of the present invention is described with reference to Figs. 3A to 3E.

Figs. 3A to 3C and 3E are respectively a cross sectional view showing a manufacturing method of a coplanar type of thin film transistor according to a third embodiment of the present invention, the thin film transistor manufactured according to the method being shown in Fig. 3E. Fig. 3D is an enlarged view of an anodic oxidation layer and a channel region shown in Fig. 3D.

As shown in Fig. 3A, polycrystalline silicon is initially deposited on the transparent glass substrate 11 according to the LP-CVD method to form a thin film. Thereafter, the polycrystalline silicon thin film is divided into a large number of island-shaped regions according to the photolithography process and the etching process to form the active semiconductor layer 12 made of the polycrystalline silicon on the substrate 11. Thereafter, silicon dioxide is deposited on the active semiconductor layer 12 and the substrate 11 according to the LP-CVD method to insulate the active semiconductor layer 12 from the outside. Therefore, the gate insulating layer 13 made of the silicon dioxide is formed on the active semiconductor layer 12. Thereafter, aluminium is deposited on the gate insulating layer 13, and the photoresist layer 14 is coated on the aluminium deposited. Thereafter, the photoresist layer 14 is patterned according to the photo lithography process, and the patterned photoresist layer 14 is removed while leaving the patterned photoresist layer 14 coated just over a central (first) portion of the active semiconductor layer 12 through the gate insulating layer 13. Thereafter, the aluminium is etched according to a taper etching process while leaving the aluminium covered with the photoresist layer 14 not removed. Therefore, a gate electrode 41 made of the aluminium is formed over the central portion of the active semiconductor layer 12 through the gate insulating layer 13. In this case, a side surface of the gate electrode 41 is inclined to form the gate electrode 41 in a taper shape, and the photoresist layer 14 coated on the gate electrode 15 is left to prevent the gate electrode 41 from being oxidized in a following step.

Thereafter, as shown in Fig. 3B, a side portion of the gate electrode 41 is oxidized according to the anodic oxidation processing performed in the solution method, so that an anodic oxidation layer 42 made of aluminium oxide is formed as a reformed layer in the side portion of the gate electrode 41. Because the aluminium oxide is an insulating material, the anodic oxidation layer 42 does not function as an electrode. Also, because the side portion of the gate electrode 41 is chemically changed to the anodic oxidation layer 42, the width of the gate electrode 41 is decreased, and the gate electrode 41 is changed to a reduced gate electrode 41R. Also, because the side portion of the gate electrode 41 reacts chemically with oxygen atoms, the side portion is swollen out while changing to the anodic oxidation layer 42. Therefore, a summed mask area of the reduced gate electrode 41R and the anodic oxidation layer 42 becomes larger than that of the gate electrode 41. In addition, even though the side portion of the gate electrode 41 is oxidized, an upper surface of the gate electrode 41 is not oxidized because the photoresist layer 14 is left on the gate electrode 41. Thereafter, the photoresist layer 14 coated just over the gate electrode 41 is removed, and a gate wiring is connected to the upper surface of the reduced gate electrode 41R.

Thereafter, as shown in Fig. 3C, impurity ions such as phosphorus are doped into the active semiconductor layer 12 through the gate insulating layer 13 according to the ion implantation method. In this case, a combined layer composed of the reduced gate electrode 41R and the anodic oxidation layer 42 functions as a mask to prevent the impurity ions from being doped into the active semiconductor layer 12, so that a source region 43 and a drain region 44 are formed in the active semiconductor layer 12 which is not positioned just under the combined layer. Also, a channel region 45 positioned just under the combined layer is formed in the active semiconductor layer 12 between the source and drain regions 43, 44. In addition, because the combined layer is in the taper shape, the combined layer incompletely functions as the mask.

In detail, as shown in Fig. 3D, the impurity ions are doped into the active semiconductor layer 12 through an inclined side portion of the combined layer, and the density of the impurity ions doped through the inclined side portion of the combined layer is inversely proportional to the thickness T₁ of the combined layer. Therefore, a lightly doped drain region 46 positioned just under an inclined side portion of the combined layer is formed in the channel region 45 adjacent to the drain region 44. The density of the impurity ions in the lightly doped drain region 46 gradually increases in the direction of the drain region 44. Also, the density of the impurity ions in the lightly doped drain region 46 gradually increases in the direction of the gate insulating layer 13. In addition, an off set region 47 positioned just under a bottom surface of the anodic oxidation layer 42 is formed in the lightly doped drain region 46 adjacent to the drain region 44.

Thereafter, as shown in Fig. 3E, silicon dioxide is deposited on the reduced gate electrode 41R and the layers 13, 42 according to the normal pressure-CVD method to insulate the reduced gate electrode 41R from the outside, so that a layer-insulation layer 48 made of the silicon dioxide is formed on the reduced gate electrode 41R and the layers 13, 42. Thereafter, contact holes reaching the source and drain regions 43, 44 through the layer-insulation layer 48 and the gate insulating layer 13 are formed according to the photo lithography process and the etching process. Thereafter, titanium is deposited on the source and drain regions 43, 44, and aluminium is deposited on the titanium. Therefore, the contact holes are buried with the titanium and the aluminium, so that a source electrode 49 and a drain electrode 50 respectively made of the titanium and the aluminium are formed. In the above steps, a thin film transistor 51 in which the off set region 47 and the lightly doped drain region 46 are formed with high precision is manufactured.

Accordingly, because the lightly doped drain region 46 is formed in a boundary region between the drain region 44 and the channel region 45 and because the impurity density of the lightly doped drain region 46 gradually decreases in the direction of the channel region 45, the off current flowing from the drain region 44 to the source region 43 in the backward bias condition can be effectively reduced.

Also, because the off set region 47 not positioned just under the reduced gate electrode 41R is formed, the intensity of the electric field induced in the off set region 47 becomes low. Therefore, the off current flowing from the drain region 44 to the source region 43 in the backward bias condition can be effectively reduced. As a result, information such as a picture signal can be stored in the thin film transistor 51 for a long time without any deterioration.

Also, as shown in Fig. 3D, because a width of the off set region 47 agrees with a horizontal width Wh of the anodic oxidation layer 42, the width of the off set region 47 can be minutely set with high precision by adjusting a thickness T₂ of the anodic oxidation layer 42 or adjusting a tilt angle ϑ of the gate electrode 41.

Also, because a width of the lightly doped drain region 46 can be minutely set by adjusting the tilt angle ϑ of the gate electrode 41, the intensity of the off current can be easily adjusted.

Also, even though the side portion of the gate electrode 41 is not swollen out when the side portion changes to the anodic oxidation layer 45, the off set region 47 can be reliably formed because the width of the off set region 47 is equivalent to a reduced width of the reduced gate electrode 41R.

Also, because the anodic oxidation layer 42 is not formed on the upper surface of the reduced gate electrode 41R, a gate wiring can be easily connected to the reduced gate electrode 41R without digging any contact hole on the reduced gate electrode 41R.

Also, even though a large number of thin film transistors 51 are manufactured on the same substrate 11, the widths of the off set regions 47 and the widths of the lightly doped drain regions 46 can be uniformly set.

In the third embodiment, the source and drain regions 43, 44 are formed after the gate electrode 41 is oxidized in the same manner as in the second embodiment. However, it is desirable that the source and drain regions 43, 44 be formed before the gate electrode 41 is oxidized in the same manner as in the first embodiment.

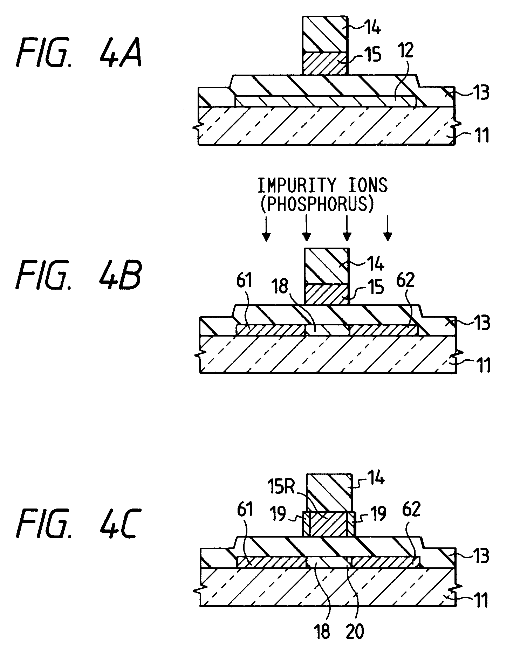

Next, a fourth embodiment of the present invention is described with reference to Figs. 4A to 4E.

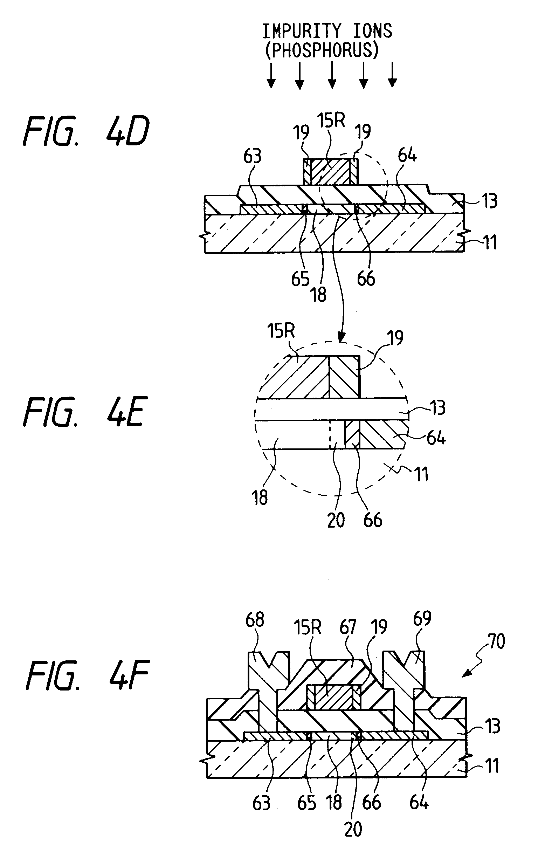

Figs. 4A to 4D and 4F are respectively a cross sectional view showing a manufacturing method of a coplanar type of thin film transistor according to a fourth embodiment of the present invention, the thin film transistor manufactured according to the method being shown in Fig. 4F. Fig. 4E is an enlarged view of an anodic oxidation layer and a channel region shown in Fig. 4D.

As shown in Fig. 4A, polycrystalline silicon is initially deposited on the transparent glass substrate 11 according to the LP-CVD method to form a thin film. Thereafter, the polycrystalline silicon thin film is divided into a large number of island-shaped regions according to the photolithography process and the etching process to form the active semiconductor layer 12 made of the polycrystalline silicon on the substrate 11. Thereafter, silicon dioxide is deposited on the active semiconductor layer 12 and the substrate 11 according to the LP-CVD method to insulate the active semiconductor layer 12 from the outside to form the gate insulating layer 13 on the active semiconductor layer 12. Thereafter, aluminium is deposited on the gate insulating layer 13, and the photoresist layer 14 is coated on the aluminium deposited. Thereafter, the photoresist layer 14 is patterned according to the photolithography process, and the patterned photoresist layer 14 is removed while leaving the patterned photoresist layer 14 coated just over a central portion of the active semiconductor layer 12 through the gate insulating layer 13. Thereafter, the aluminium is etched according to the etching process while leaving the aluminium covered with the photoresist layer 14 not removed to form the gate electrode 15 over the central portion of the active semiconductor layer 12 through the gate insulating layer 13. In this case, the photoresist layer 14 coated on the gate electrode 15 is left to prevent the gate electrode 15 from being oxidized in a following step.

Thereafter, as shown in Fig. 4B, impurity ions such as phosphorus are slightly doped into the active semiconductor layer 12 through the gate insulating layer 13 according to the ion implantation method. In this case, the photoresist layer 14 and the gate electrode 15 function as a mask to prevent the impurity ions from being doped into the active semiconductor layer 12. Therefore, a source region 61 and a drain region 62 respectively doped in a low impurity density are formed in the active semiconductor layer 12, and the channel region 18 not doped by the impurity ions is formed in the active semiconductor layer 12 positioned just under the gate electrode 15.

Thereafter, as shown in Fig. 4C, a side portion of the gate electrode 15 is oxidized according to the anodic oxidation processing performed in the solution method to form the anodic oxidation layer 19 made of aluminium oxide. Because the aluminium oxide is an insulating material, the anodic oxidation layer 19 does not function as an electrode. Also, because the side portion of the gate electrode 15 is chemically changed to the anodic oxidation layer 19, the width of the gate electrode 15 is decreased, and the gate electrode 15 is changed to a reduced gate electrode 15R. Therefore, the channel region 18 adjacent to the source and drain regions 61, 62 is not positioned just under the reduced gate electrode 15R. Accordingly, the off set region 20, which is not positioned just under the reduced gate electrode 15R, is formed in the channel region 18 adjacent to the drain region 62.

Also, because the side portion of the gate electrode 15 reacts chemically with oxygen atoms, the side portion is swollen out while changing to the anodic oxidation layer 19. Therefore, a summed mask area of the reduced gate electrode 15R and the anodic oxidation layer 19 becomes larger than that of the gate electrode 15. In addition, even though the side portion of the gate electrode 15 is oxidized, an upper surface of the gate electrode 15 is not oxidized because the photoresist layer 14 is left on the gate electrode 15. Thereafter, the photoresist layer 14 coated just over the gate electrode 15 is removed, and a gate wiring is connected to the upper surface of the reduced gate electrode 15R.

Thereafter, as shown in Fig. 4D, impurity ions such as phosphorus are heavily doped into the source and drain regions 61, 62 through the gate insulating layer 13 according to the ion implantation method while functioning the reduced gate electrode 15R and the anodic oxidation layer 19 as a mask to prevent the impurity ions from being doped into the channel region 18. Therefore, a source region 63 and a drain region 64 respectively doped in a high impurity density are formed in the source and drain regions 61, 62. In this case, as shown in Fig. 4E, because the summed mask area of the reduced gate electrode 15R and the anodic oxidation layer 19 is larger than that of the gate electrode 15, portions of the source and drain regions 61, 62 respectively adjacent to the channel region 18 are positioned just under the anodic oxidation layer 19. Therefore, the portions of the source and drain regions 61, 62 are not heavily doped with the impurity ions. The portions are called lightly doped drain regions 65, 66. The lightly doped drain region 65 is positioned between the source region 63 and the channel region 18, and the lightly doped drain region 66 is positioned between the drain region 64 and the channel region 18.

Thereafter, as shown in Fig. 4F, silicon dioxide is deposited on the reduced gate electrode 15R and the layers 13, 19 according to the normal pressure-CVD method to insulate the reduced gate electrode 15R from the outside, so that a layer-insulation layer 67 made of the silicon dioxide is formed on the reduced gate electrode 15R and the layers 13, 19. Thereafter, contact holes reaching the source and drain regions 63, 64 through the layer-insulation layer 67 and the gate insulating layer 13 are formed according to the photo lithography process and the etching process. Thereafter, titanium is deposited on the source and drain regions 63, 64 and aluminium is deposited on the titanium. Therefore, the contact holes are buried with the titanium and the aluminium, so that a source electrode 68 and a drain electrode 69 respectively made of the titanium and the aluminium are formed. In the above steps, a thin film transistor 70 in which the off set region 20 is formed with high precision is manufactured.

Accordingly, because the lightly doped drain region 66 is formed in a boundary region between the drain region 62 and the channel region 18 and because the impurity density of the lightly doped drain region 46 is arbitrarily adjusted by slightly doping the impurity ions, the off current flowing from the drain region 62 to the source region 61 in the backward bias condition can be effectively reduced. Also, because a width of the lightly doped drain region 66 agrees with a swelling width of the anodic oxidation layer 19, the width of the lightly doped drain region 66 can be minutely set with high precision.

Also, because the off set region 20 not positioned just under the reduced gate electrode 41R is formed, the intensity of the electric field induced in the off set region 20 becomes low. Therefore, the off current flowing from the drain region 62 to the source region 61 in the backward bias condition can be effectively reduced. As a result, information such as a picture signal can be stored in the thin film transistor 51 for a long time without any deterioration. Also, because a width of the off set region 20 agrees with a reduced width of the reduced gate electrode 15R, the width of the off set region 20 can be minutely set with high precision.

Also, because the anodic oxidation layer 19 is not formed on the upper surface of the reduced gate electrode 15R, a gate wiring can be easily connected to the reduced gate electrode 15R without digging any contact hole on the reduced gate electrode 15R.

Also, even though a large number of thin film transistors 70 are manufactured on the same substrate 11, the widths of the off set regions 20 and the widths of the lightly doped drain regions 66 can be uniformly set.

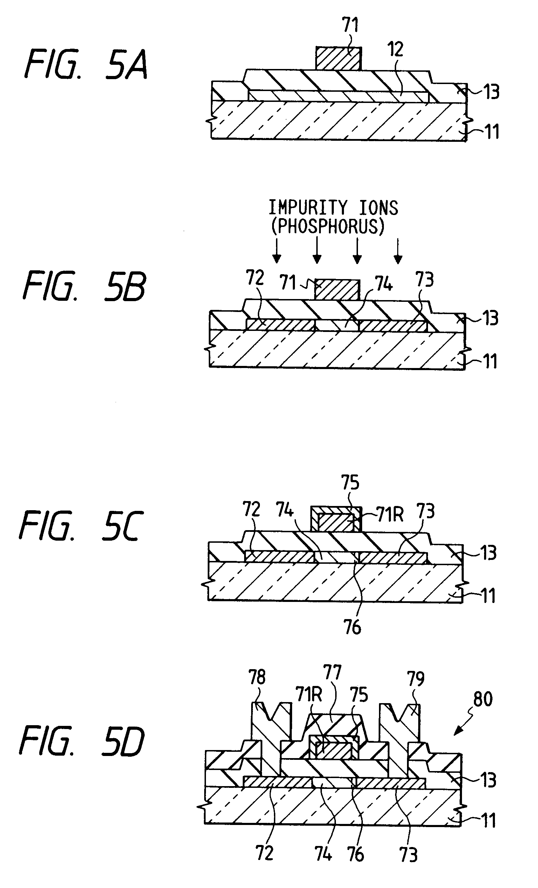

Next, a fifth embodiment of the present invention is described with reference to Figs. 5A to 5D.

Figs. 5A to 5D are respectively a cross sectional view showing a manufacturing method of a coplanar type of thin film transistor according to a fifth embodiment of the present invention, the thin film transistor manufactured according to the method being shown in Fig. 5D.

As shown in Fig. 5A, polycrystalline silicon is initially deposited on the transparent glass substrate 11 according to the LP-CVD method to form a thin film. Thereafter, the polycrystalline silicon thin film is divided into a large number of island-shaped regions according to the photolithography process and the etching process to form the active semiconductor layer 12 made of the polycrystalline silicon on the substrate 11. Thereafter, silicon dioxide is deposited on the active semiconductor layer 12 and the substrate 11 according to the LP-CVD method to insulate the active semiconductor layer 12 from the outside to form the gate insulating layer 13 on the active semiconductor layer 12. Thereafter, aluminium is deposited on the gate insulating layer 13 and is patterned according to the photolithography process and the etching process. Therefore, a gate electrode 71 is formed over a central portion of the active semiconductor layer 12 through the gate insulating layer 13.

Thereafter, as shown in Fig. 5B, impurity ions such as phosphorus are doped into the active semiconductor layer 12 through the gate insulating layer 13 according to the ion implantation method. In this case, the gate electrode 71 functions as a mask to prevent the impurity ions from being doped into the active semiconductor layer 12. Therefore, a source region 72 and a drain region 73 respectively doped in an impurity density are formed in the active semiconductor layer 12, and a channel region 74 not doped with the impurity ions is formed in the active semiconductor layer 12 positioned just under the gate electrode 71.

Thereafter, as shown in Fig. 5C, an entire surface portion of the gate electrode 71 is oxidized according to the anodic oxidation processing performed in the solution method. Therefore, an anodic oxidation layer 75 made of aluminium oxide is formed as a reformed layer at the entire surface portion of the gate electrode 71. Because the aluminium oxide is an insulating material, the anodic oxidation layer 75 does not function as an electrode. Also, because the entire surface portion of the gate electrode 71 is chemically changed to the anodic oxidation layer 75, the size of the gate electrode 71 is decreased, and the gate electrode 71 is changed to a reduced gate electrode 71R. Therefore, a portion of the channel region 74 adjacent to the source and drain regions 72, 73 is not positioned just under the reduced gate electrode 71R. Accordingly, an off set region 76, which is not positioned just under the reduced gate electrode 71R, is formed at the portion of the channel region 74 adjacent to the drain region 73.

Also, because the entire surface portion of the gate electrode 71 reacts chemically with oxygen atoms, the entire surface portion is swollen out while changing to the anodic oxidation layer 75. Therefore, a summed mask area of the reduced gate electrode 71R and the anodic oxidation layer 75 becomes larger than that of the gate electrode 71.

Thereafter, as shown in Fig. 5D, silicon dioxide is deposited on the reduced gate electrode 71R and the layers 13, 75 according to the normal pressure-CVD method to insulate the reduced gate electrode 71R from the outside, so that a layer-insulation layer 77 made of the silicon dioxide is formed on the reduced gate electrode 71R and the layers 13, 75. Thereafter, contact holes reaching the source and drain regions 72, 73 through the layer-insulation layer 77 and the gate insulating layer 13 are formed according to the photo lithography process and the etching process. Thereafter, titanium is deposited on the source and drain regions 72, 73, and aluminium is deposited on the titanium. Therefore, the contact holes are buried with the titanium and the aluminium, so that a source electrode 78 and a drain electrode 79 respectively made of the titanium and the aluminium are formed. Also, a gate wiring is connected to the reduced gate electrode 71R after a contact hole is formed on the reduced gate electrode 71R. In the above steps, a thin film transistor 80 in which the off set region 76 is formed with high precision is manufactured.

Accordingly, because the off set region 76 not positioned just under the reduced gate electrode 71R is formed, the intensity of electric field induced in the off set region 76 becomes low. Therefore, the off current flowing from the drain region 73 to the source region 72 can be effectively reduced in the backward bias condition, and information such as a picture signal can be stored in the thin film transistor 80 for a long time without any deterioration.

Also, because a width of the off set region 76 agrees with a reduced width of the reduced gate electrode 71R, the width of the off set region 76 can be minutely set with high precision by adjusting the reduced width of the reduced gate electrode 71R.

Also, because the entire surface of the reduced gate electrode 71R is covered with the anodic oxidation layer 75, the reduced gate electrode 71R can be reliably insulated from a source wiring and a drain wiring.

Also, even though a large number of thin film transistors 80 are manufactured on the same substrate 11, the widths of the off set regions 76 can be uniformly set.

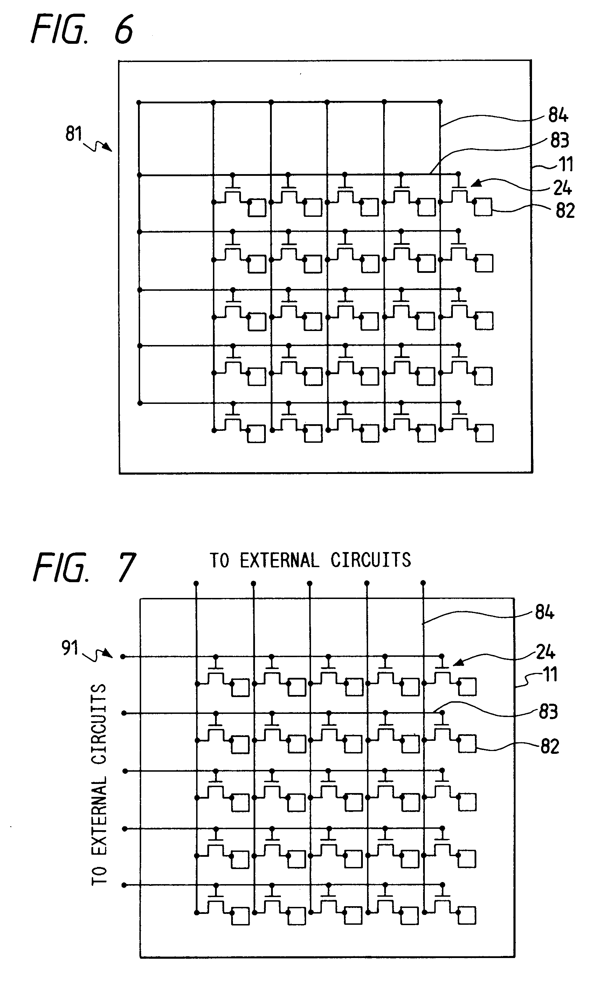

Next, a sixth embodiment of the present invention is described with reference to Fig. 6.

Fig. 6 is a schematic plan view of a semiconductor apparatus according to a sixth embodiment of the present invention.

As shown in Fig. 6, a semiconductor apparatus 81 comprises the transparent glass substrate 11, a large number of thin film transistors 24 set in array on the transparent glass substrate 11, pixel electrodes 82 electrically connected with the drain regions 17, gate bus wirings 83 connected with the reduced gate electrodes 15R, and source bus wirings 84 connected with the source electrodes 22. Each of the pixel electrodes 82 is a transparent electrode made of indium-tin-oxide. The gate bus wirings 83 are connected to each other, so that all of the gate electrodes 15 of the thin film transistors 24 can be simultaneously oxidized according to the anodic oxidation processing by supplying an electric current to a common line of the gate bus wirings 83. Also, the gate bus wirings 83 and the source bus wirings 84 are connected to each other, so that dielectric breakdown of the thin film transistors 24 resulting from charge-up undesirably generated during the manufacturing of the semiconductor apparatus 81 can be prevented.

Accordingly, because no anodic oxidation layer is arranged on the reduced gate electrodes 15R, the gate bus wirings 83 can be easily connected with the reduced gate electrodes 15R without digging any contact hole on the reduced gate electrodes 15R.

Also, the off set regions 20 can be uniformly formed in the thin film transistors 24 because all of the gate electrodes 15 are simultaneously oxidized according to the anodic oxidation processing by supplying an electric current to the common line. Therefore, storing characteristics of the semiconductor apparatus 81 can be improved.

Next, a seventh embodiment of the present invention is described with reference to Fig. 7.

Fig. 7 is a schematic plan view of a semiconductor apparatus according to a seventh embodiment of the present invention.

As shown in Fig. 7, a semiconductor apparatus 91 comprises the transparent glass substrate 11, a large number of thin film transistors 24 set in array on the transparent glass substrate 11, pixel electrodes 82 electrically connected with the drain regions 17, gate bus wirings 83 connected with the reduced gate electrodes 15R, and source bus wirings 84 connected with the source electrodes 22. Each of the pixel electrodes 82 is a transparent electrode made of indium-tin-oxide. Each of the gate bus wirings 83 are connected to an external circuit, and each of the source bus wirings 84 are connected to another external circuit.

Accordingly, because no anodic oxidation layer is arranged on the reduced gate electrodes 15R, the gate bus wirings 83 can be easily connected with the reduced gate electrodes 15R without digging any contact hole on the reduced gate electrodes 15R.

Also, the off set regions 20 can be uniformly formed in the thin film transistors 24 when the gate electrodes 15 are charged for the same time. Therefore, storing characteristics of the semiconductor apparatus 91 can be improved.

In the sixth and seventh embodiments, each of the thin film transistors 24 is manufactured according to the first embodiment. However, the sixth and seventh embodiments are not limited to the transistors 24. That is, it is desirable that a large number of thin film transistors 39, 51, 70, or 80 manufactured according to one embodiment selected from a group of the second to fifth embodiments be set in array in place of the transistors 24.

In the first to fourth embodiments, the photoresist 14 is left on the gate electrode 15 or 41 when the gate electrode 15 or 41 is oxidized according to the anodic oxidation processing to prevent the upper portion of the gate electrode 15 from being oxidized. However, an anti-oxidation material preventing the oxidation of the upper portion of the gate electrode 15 is not limited to the photoresist 14 in the first to fourth embodiments. That is, it is desirable that photosensitive polyimide is left on the gate electrode 15 or 41.

In the first to seventh embodiments, aluminium is utilized as a material of the gate electrodes 15, 41, and 71. However, the material of the gate electrodes 15, 41, and 71 is not limited to the aluminium. For example, a conductive material such as tantalum, aluminium alloy or tantalum alloy is desirable as the material of the gate electrodes 15, 41, and 71 on condition that the conductive material can be easily oxidized according to the anodic oxidation processing and functions as a mask against the impurity ions.

In the first to seventh embodiments, the anodic oxidation processing of the solution method is utilized to form the anodic oxidation layers 19, 31, 42, 75 as the reformed layers. However, a forming method of the reformed layer is not limited to the solution method, and the forming method such as a thermal oxidation method, a plasma oxidation method, or a plasma nitriding method is desirable on condition that the reformed layer made of an insulating material is formed while the side portion of the gate electrode is swollen out.

In the first to seventh embodiments, phosphorus is utilized as an impurity material. However, the impurity material is not limited to the phosphorus. For example, the impurity material such as arsenic functioning as a donor is desirable in cases where an n channel type of thin film transistor is manufactured, and the impurity material such as boron functioning as an acceptor is desirable in cases where a p channel type of thin film transistor is manufactured.

In the first to seventh embodiments, the gate insulating layer 13 and the layer-insulation layers 21, 36, 48, 67, and 77 are respectively formed by the silicon dioxide deposited according to the LP-CVD method or the normal pressure CVD method. However, it is desirable that an insulating material such as silicon nitride be deposited according to a plasma CVD method.

In the first to seventh embodiments, the polycrystalline silicon is utilized as a material of the active semiconductor layer 12. However, the material of the active semiconductor layer 12 is not limited. For example, amorphous silicon, microcrystal silicon, monocrystal silicon, or compound semiconductor material is desirable as the material of the active semiconductor layer 12.

In the first to seventh embodiments, the ion implantation method is utilized to dope the impurity ions into the active semiconductor layer 12. However, the embodiments are not limited to the ion implantation method. For example, any impurity implantation method is desirable on condition that impurities ions included in a high frequency discharge plasma are accelerated without any mass separation and are doped into the active semiconductor layer 12.

Having illustrated and described the principles of our invention in a preferred embodiment thereof, it should be readily apparent to those skilled in the art that the invention can be modified in arrangement and detail without departing from such principles. We claim all modifications coming within the spirit and scope of the accompanying claims.

A manufacturing method of a thin film transistor consists of the steps of depositing an active semiconductor layer, a gate insulating layer, and a gate electrode on a transparent glass substrate in that order, forming source and drain regions by doping impurities into the active semiconductor layer according to an ion implantation method while functioning the gate electrode as a mask against the impurities, oxidizing a side portion of the gate electrode according to an anodic oxidation processing to form an anodic oxidation layer made of an insulating material, depositing a layer-insulation layer on the gate electrode and the anodic oxidation layer, and connecting source and drain electrodes to the source and drain regions. A channel region not doped with the impurities is formed in the active semiconductor layer between the source and drain regions, and an off set region positioned just under the anodic oxidation layer is formed in a portion of the channel region adjacent to the drain region. Therefore, an off current flowing from the drain region to the source region is decreased in a backward bias condition because of the off set region, so that a picture signal can be stored in the thin film transistor for a long time.

## Claims

1. A manufacturing method of a thin film transistor, comprising the steps of:
forming a semiconductor thin layer on a transparent insulating substrate;
forming an insulating layer on the semiconductor thin layer;
forming a gate electrode on the insulating layer, the gate electrode being positioned over a first portion of the semiconductor thin layer;
doping impurities into second portions of the semiconductor thin layer by utilizing the gate electrode as a mask which prevents the impurities from passing though the gate electrode, the second portions of the semiconductor thin layer doped with the impurities being changed to a source region and a drain region, and a channel region not doped with the impurities being formed in the first portion of the semiconductor thin layer which is positioned just under the gate electrode and is positioned between the source and drain regions; and
reforming a side portion of the gate electrode to a reformed layer made of an insulating material to form an off set region which is positioned in a portion of the channel region adjacent to the drain region and positioned just under the reformed layer, intensity of electric field induced in the channel region by applying a voltage to the gate electrode of which the side portion is reformed being lowered in the off set region.

2. A method according to claim 1 in which the step of reforming a side portion includes:
oxidizing the side portion of the gate electrode according to an anodic oxidation processing to form an anodic oxidation layer as the reformed layer.

3. A method according to claim 2 in which the gate electrode is made of a conductive material selected from the group consisting of aluminium, tantalum, aluminium alloy, and tantalum alloy.

4. A method according to claim 1 in which the semiconductor thin film is made of a material selected from the group consisting of polycrystalline silicon, amorphous silicon, microcrystal silicon, monocrystal silicon, and compound semiconductor material.

5. A method according to claim 1 in which the step of doping impurities includes:
generating a high frequency discharge plasma in which ions of the impurities are included; and
accelerating the impurity ions to dope the impurity ions into the second portions of the semiconductor thin layer.

6. A method according to claim 1 in which the step of reforming a side portion includes:
arranging an anti-oxidation material on an upper portion of the gate electrode, the anti-oxidation material being selected from the group consisting of a photoresist and a photosensitive polyimide;
selectively oxidizing the side portion of the gate electrode according to an anodic oxidation processing to form an anodic oxidation layer as the reformed layer; and
removing the anti-oxidation material from the upper portion of the gate electrode.

7. A method according to claim 1 in which the step of forming a gate electrode includes:
etching the gate electrode in a taper shape to incline a side surface of the gate electrode, and
the step of doping impurities includes:
incompletely functioning the side portion of the gate electrode as the mask against the impurities to form a lightly doped drain region in a portion of the channel region adjacent to the drain region, density of the impurities in the lightly doped drain region being gradually increased in the direction of the drain region in inversely proportional to a thickness of the gate electrode through which the impurities pass.

8. A manufacturing method of a thin film transistor, comprising the steps of:
forming a semiconductor thin layer on a transparent insulating substrate;
forming an insulating layer on the semiconductor thin layer;
forming a gate electrode on the insulating layer, the gate electrode being positioned over a first portion of the semiconductor thin layer;
reforming a side portion of the gate electrode to a reformed layer made of an insulating material, the gate electrode being changed to a reduced gate electrode; and
doping impurities into second portions of the semiconductor thin layer by utilizing both the reduced gate electrode and the reformed layer as a mask which prevents the impurities from passing though both the reduced gate electrode and the reformed layer, the second portions of the semiconductor thin layer doped with the impurities being changed to a source region and a drain region, a channel region not doped with the impurities being formed in the semiconductor thin layer which is positioned just under both the reduced gate electrode and the reformed layer and is positioned between the source and drain regions, an off set region positioned just under the reformed layer being formed in a portion of the channel region adjacent to the drain region, and intensity of electric field induced in the channel region by applying a voltage to the reduced gate electrode being lowered in the off set region.

9. A method according to claim 8 in which the step of reforming a side portion includes:
oxidizing the side portion of the gate electrode according to an anodic oxidation processing to form an anodic oxidation layer as the reformed layer.

10. A method according to claim 9 in which the gate electrode is made of a conductive material selected from the group consisting of aluminium, tantalum, aluminium alloy, and tantalum alloy.

11. A method according to claim 8 in which the semiconductor thin film is made of a material selected from the group consisting of polycrystalline silicon, amorphous silicon, microcrystal silicon, monocrystal silicon, and compound semiconductor material.

12. A method according to claim 8 in which the step of doping impurities includes:
generating a high frequency discharge plasma in which ions of the impurities are included; and
accelerating the impurity ions to dope the impurity ions into the second portions of the semiconductor thin layer.

13. A method according to claim 8 in which the step of reforming a side portion includes:
arranging an anti-oxidation material on an upper portion of the gate electrode, the anti-oxidation material being selected from the group consisting of a photoresist and a photosensitive polyimide;
selectively oxidizing the side portion of the gate electrode according to an anodic oxidation processing to form an anodic oxidation layer as the reformed layer; and
removing the anti-oxidation material from the upper portion of the gate electrode.

14. A method according to claim 8 in which the step of forming a gate electrode includes:
etching the gate electrode in a taper shape to incline a side surface of the gate electrode, and
the step of doping impurities includes:
incompletely functioning the reformed layer and an inclined portion of the reduced gate electrode adjacent to the reformed layer as the mask against the impurities to form a lightly doped drain region in a portion of the channel region adjacent to the drain region, density of the impurities in the lightly doped drain region being gradually increased in the direction of the drain region in inversely proportional to a thickness of the gate electrode through which the impurities pass.

15. A manufacturing method of a thin film transistor, comprising the steps of:
forming a semiconductor thin layer on a transparent insulating substrate;
forming an insulating layer on the semiconductor thin layer;
forming a gate electrode on the insulating layer, the gate electrode being positioned over a first portion of the semiconductor thin layer;
slightly doping first impurities into second portions of the semiconductor thin layer by utilizing the gate electrode as a mask which prevents the first impurities from passing though the gate electrode, the second portions of the semiconductor thin layer doped with the first impurities being changed to a source region slightly doped and a drain region slightly doped, and a channel region not doped with the first impurities being formed in the first portion of the semiconductor thin layer which is positioned just under the gate electrode and is positioned between the source and drain regions slightly doped;
reforming a side portion of the gate electrode to a reformed layer made of an insulating material to form an off set region positioned just under the reformed layer in the channel region adjacent to the drain region, the gate electrode being changed to a reduced gate electrode, intensity of electric field induced in the channel region by applying a voltage to the reduced gate electrode being lowered in the off set region, and the reformed layer being formed while the side portion of the gate electrode is swollen out to position a first portion of the drain region adjacent to the off set region just under the reformed layer; and
heavily doping second impurities into the source and drain regions slightly doped by utilizing both the reduced gate electrode and the reformed layer as a mask which prevents the second impurities from passing though both the reduced gate electrode and the reformed layer, the source and drain regions doped with the second impurities being changed to the source and drain regions heavily doped, the first portion of the drain region being not heavily doped with the second impurities to function as a lightly doped drain region positioned between the off set region and the drain region heavily doped.

16. A method according to claim 15 in which the step of reforming a side portion includes:
oxidizing the side portion of the gate electrode according to an anodic oxidation processing to form an anodic oxidation layer as the reformed layer.

17. A method according to claim 16 in which the gate electrode is made of a conductive material selected from the group consisting of aluminium, tantalum, aluminium alloy, and tantalum alloy.

18. A method according to claim 15 in which the semiconductor thin film is made of a material selected from the group consisting of polycrystalline silicon, amorphous silicon, microcrystal silicon, monocrystal silicon, and compound semiconductor material.

19. A method according to claim 15 in which the step of slightly doping first impurities includes:
generating a high frequency discharge plasma in which ions of the first impurities are included; and
accelerating the first impurity ions to dope the first impurity ions into the second portions of the semiconductor thin layer, and
the step of heavily doping second impurities includes:
generating a high frequency discharge plasma in which ions of the second impurities are included; and
accelerating the second impurity ions to dope the second impurity ions into the source and drain regions slightly doped.

20. A method according to claim 15 in which the step of reforming a side portion includes:
arranging an anti-oxidation material on an upper portion of the gate electrode, the anti-oxidation material being selected from the group consisting of a photoresist and a photosensitive polyimide;
selectively oxidizing the side portion of the gate electrode according to an anodic oxidation processing to form an anodic oxidation layer as the reformed layer; and
removing the anti-oxidation material from the upper portion of the gate electrode.

21. A thin film transistor comprising:
a transparent insulating substrate;
a source region arranged on the transparent insulating substrate;
a drain region arranged on the transparent insulating substrate;
a channel region arranged between the source and drain regions, charged particles being transferred from the source region to the drain region through the channel region;
an insulating layer for insulating the source region, the drain region, and the channel region;
a gate electrode arranged on the insulating layer just over a first portion of the channel region to form an off set region which is positioned in a second portion of the channel region adjacent to the drain region and is not positioned just under the gate electrode; and
a reformed layer made of an insulating material surrounding a side surface of the gate electrode, the reformed layer being formed by reforming a side portion of the gate electrode, and the off set region being positioned just under the reformed layer.

22. A thin film transistor according to claim 21 in which a portion of the drain region adjacent to the off set region is positioned just under the reformed layer.

23. A thin film transistor according to claim 21 in which the gate electrode is made of a conductive material selected from the group consisting of aluminium, tantalum, aluminium alloy, and tantalum alloy, and the reformed layer is made of an oxide of the conductive material.

24. A thin film transistor according to claim 21 in which the gate electrode has an inclined side surface in a taper shape, and the channel region has a slightly doped drain region in a portion just under the reformed layer and the inclined side surface of the gate electrode.

25. A thin film transistor according to claim 21 in which the drain region has a slightly doped drain region in a portion adjacent to the off set region, the slightly doped drain region being positioned just under the reformed layer.

26. A thin film transistor according to claim 21, additionally including:
a second reformed layer made of an insulating material which is arranged on the gate electrode to insulate the gate electrode in cooperation with the reformed layer, the second reformed layer being formed by reforming an upper portion of the gate electrode.

27. A semiconductor apparatus, comprising:
a transparent insulating substrate;
a thin film transistor array composed of a plurality of thin film transistors arranged in array on the transparent insulating substrate, each of the thin film transistor comprising
a source region arranged on the transparent insulating substrate;
a drain region arranged on the transparent insulating substrate;
a channel region arranged between the source and drain regions, charged particles being transferred from the source region to the drain region through the channel region;
an insulating layer for insulating the source region, the drain region, and the channel region;
a gate electrode arranged on the insulating layer just over a first portion of the channel region to form an off set region which is positioned in a second portion of the channel region adjacent to the drain region and is not positioned just under the gate electrode; and
a reformed layer made of an insulating material surrounding a side surface of the gate electrode, the reformed layer being formed by reforming a side portion of the gate electrode, and the off set region being positioned just under the reformed layer.
a plurality of gate bus wirings, connected to the gate electrodes of the thin film transistors in the thin film transistor array, for transferring gate signals to the gate electrodes;
a plurality of source bus wirings, connected to the source regions of the thin film transistors in the thin film transistor array, for transferring picture signals to the source regions; and
a plurality of pixel electrodes connected to the drain regions for storing the picture signals transferred from the source bus wirings through the source regions under control of the gate signals applied to the gate electrodes through the gate bus wirings.

28. A semiconductor apparatus according to claim 27 in which the gate and source bus wirings are connected to each other.

29. A semiconductor apparatus according to claim 27 in which the gate bus wirings are respectively connected to an external circuit, and the source bus wirings are respectively connected to another external circuit.

30. A semiconductor apparatus according to claim 27 in which a portion of the drain region adjacent to the off set region is positioned just under the reformed layer.

31. A semiconductor apparatus according to claim 27 in which the gate electrode is made of a conductive material selected from the group consisting of aluminium, tantalum, aluminium alloy, and tantalum alloy, and the reformed layer is made of an oxide of the conductive material.

32. A semiconductor apparatus according to claim 27 in which the gate electrode has an inclined side surface in a taper shape, and the channel region has a slightly doped drain region in a portion just under the reformed layer and the inclined side surface of the gate electrode.

33. A semiconductor apparatus according to claim 27 in which the drain region has a slightly doped drain region in a portion adjacent to the off set region, the slightly doped drain region being positioned just under the reformed layer.

34. A semiconductor apparatus according to claim 27, additionally including:
a second reformed layer made of an insulating material which is arranged on the gate electrode to insulate the gate electrode in cooperation with the reformed layer, the second reformed layer being formed by reforming an upper portion of the gate electrode.
